# EUROPEAN PATENT APPLICATION

(11) **EP 2 371 993 A1**
(43) Date of publication of application: **05.10.2011**
(21) Application number: 11250378.4
(22) Date of filing: 25.03.2011
(51) Int. Cl.: C23C 16/455, A44C 27/00

(54) **Method of surface treatment and surface treated article provided by the same**

(30) Priority: 26.03.2010 US 732668
(71) Applicant: National Tsing Hua University, Hsinchu 30013 (TW)
(72) Inventor: Hsu, Wen-Kuang, Hsinchu, Taiwan 30013 (TW); Tang, Chiung-Wen, Hsinchu, Taiwan 30013 (TW); Kuo, Hsin-Fu, Hsinchu, Taiwan 30013 (TW); Jenq, Po-Wen, CA 95014 (US)
(74) Representative: Hall, Matthew Benjamin

(57) **Abstract**

A method of surface treatment and surface treated article provided by the same are disclosed. The method of surface treatment of the present invention comprises: providing a substrate; and forming a ceramic layer on a surface of the substrate by atomic layer deposition (ALD), wherein the ceramic layer has a thickness of 1nm to 1000nm. The method of surface treatment of the present invention utilizes an atomic layer deposition (ALD) method to form a ceramic layer on a surface of the substrate, in which the formed ceramic layer has excellent uniformity and is randomly and entirely coated on the surface of the substrate. Therefore, the substrate surface treated by the method of the present invention is able to have a color the same as or different to that of the surface of the substrate and simultaneously prevent oxidation/tarnish occurring.

## Description

The present invention relates to a method of surface treatment and a surface treated article treated by the same and, more particularly, to method of surface treatment using an atomic layer deposition method and a surface treated article treated by the same.

Articles such as an earring, a necklace, antique, or a housing for mobile devices can be subject to soiling, dulling or tarnish formation due to atmospheric contaminants, environmental conditions or by handling and use. Therefore, such articles usually undergo surface treatment for improving surface durability, and also, for the improvement of the decorative quality. A number of surface treatments are possible including electroplating, immersion plating, or dip coating to form a thin film on the substrate to obtain decorative or tarnish-preventing purposes.

In US-A-2007/213216, a method of producing a configured wind ornament is disclosed, in which dye sublimation inks are coated for coloring the wind ornament. In US-A-2007/277702, a coating composition is disclosed, which comprises an organic pigment or dye and fibrous inorganic clay and can be applied for coloring of the articles.

In US-A-2004/244671, a tarnish-resistant handbell is disclosed, wherein a vapor deposited nitride layer is coated on the handbell to provide tarnish resistance to the coated article. The deposited nitride layer has a thickness of 0.15 to 1.0 microns.

However, such coating methods usually provide a film with thickness over microns in size so as to obtain sufficient chemical-resistance and coloration quality, which may be subjected to limitation on the improvement of the surface texture and the decorative quality of the applied articles. For example, a silver ring may have a plastic texture when the coated film is too thick, and the outer appearance may be unsatisfactory since the thick-coated film is not completely transparent.

Therefore, a surface treatment process for coloring metal articles is desired, which should be able to form a very thin film on the article to avoid the plastic texture, to prevent article tarnish, and also to provide adjustable coloration purposes or completely transparent coatings simultaneously.

According to a first aspect of the present invention, there is provided a method of surface treatment, which comprises: providing a substrate; and forming a ceramic layer on a surface of the substrate by atomic layer deposition (ALD), wherein the ceramic layer has a thickness of 1nm to 1000 nm.

According to a second aspect, there is provided a surface treated article, which comprises an article coated with a ceramic layer by atomic layer deposition (ALD), wherein the coated ceramic layer has a thickness of 1nm to 1000 nm.

The method of surface treatment of the present invention utilizes an atomic layer deposition (ALD) method to form a ceramic layer on a surface of the substrate, in which the formed ceramic layer has excellent uniformity and is randomly and entirely coated on the surface of the substrate without shape concern. Therefore, the substrate surface treated by the method of the present invention is able to have a color the same as or different to that of the surface of the substrate and simultaneously prevent oxidation/tarnish occurring.

According to the method of surface treatment of the present invention, preferably the substrate may have an irregular shape. The shape of the substrate of the present invention is unlimited. In detail, the substrate of the present invention may be any article such as a ring, an earring, a necklace, a housing for mobile devices, stationery devices such as scissors or staplers, candlesticks, door knobs, etc, which means the surface treatment method of the present invention can be applied into various articles' surfaces without specific limitations.

According to the method of surface treatment of the present invention, preferably a material of the ceramic layer may be selected from a group consisted of: Al₂O₃, ZnO, TiO₂ ZrO₂ AlN, GaN, BN, TiN, SiC, Si₃N₄ and mixtures thereof, but is not limited thereto. Meanwhile, the precursors used in the atomic layer deposition should vary depending on different selected ceramic materials. For example, when Al₂O₃ is selected as the material of the ceramic layer in the method of the present invention, trimethyl aluminum (TMA) and water may be used as the precursors in the atomic layer deposition process. Alternatively, when ZnO is selected as the material of the ceramic layer, diethyl zinc (DEZ) and water may be used as the precursors. Therefore, the precursors used during the atomic layer deposition process should be properly selected corresponding to the ceramic material.

According to the method of surface treatment of the present invention, preferably the thickness of the ceramic layer may be 1 to 400nm. The thickness of the ceramic layer of the present invention can be extremely thin (less than one micrometer) with high uniformity simultaneously and therefore the undesirable textures can be improved (i.e. the plastic texture can be avoided). Meanwhile, when the ceramic layer of the present invention has a thickness of about 1-10nm, the ceramic layer is thoroughly transparent. Alternatively, when the thickness of the ceramic layer is about over 10nm, desirable colors of the coated substrate can be revealed arbitrarily and changed thereby to achieve the improvement of the decorative quality.

According to the method of surface treatment of the present invention, preferably the method of surface treatment is used to change the color of the surface of the substrate. Also, preferably the color of the ceramic layer-coated substrate differs with different thicknesses of the ceramic layer. In the present invention, the color of the ceramic layer-coated substrate differs with different thicknesses of the ceramic layer. For example, when a ceramic layer of Al₂O₃ is formed on a silicon wafer in a thickness ranging from about 10nm to 250nm by using the method of the present invention, the color of the ceramic layer-coated substrate gradually changes from dark yellow to blue green with the increase of the layer thickness. The sequence of the changed color is sequentially: dark yellow, blue violet, deep blue, blue, light blue, green, light gold, magenta, and blue green. When the thickness of the ceramic layer is over 250nm, the color will be changed repeatedly as the above changing sequence except the dark yellow color, which means the color of the ceramic layer will change from blue violet again to blue green and repeat to change from blue violet with the increasing of the film thickness.

In the present invention, the color change sequence is different with respective ceramic materials. For example, when AlN is used as the ceramic material, the color change sequence is different from that of an Al₂O₃ layer. Therefore, the using of different ceramic materials is able to give desirable colors to the coated article. Hence, the method of the present invention can be applied to improve the decorative quality of the articles.

According to the method of surface treatment of the present invention, preferably the forming of the ceramic layer by atomic layer deposition can be repeated for 1 to 10000 times (i.e. cycles). The repeating of the atomic layer deposition may contribute to uniformly increase the thickness of the ceramic layer.

According to the method of surface treatment of the present invention, preferably the method of surface treatment is used to prevent oxidation of the substrate. From the corrosion testing result of the present invention, it is proved that the formed ceramic layer is able to prevent tarnish.

According to the method of surface treatment of the present invention, preferably the substrate can be a metal substrate (i.e. metal article), a glass substrate (i.e. glass article), a quartz substrate (i.e. quartz article), a polymer substrate (i.e. polymer article), for example, a polycarbonate (PC) product, or a Polyethylene terephthalate (PET) film. In the present invention, the shape and the material of the substrate is unlimited, which means the surface treatment method of the present invention can be applied into various articles' surface treatment without specific limitations.

According to the method of surface treatment of the present invention, preferably a reacting temperature of the atomic layer deposition method is 50 to 650 °C.

The present invention also provides a surface treated article, which comprises an article coated with a ceramic layer by atomic layer deposition (ALD), wherein the coated ceramic layer has a thickness of 1nm to 1000nm. The surface treated article of the present invention can meet the requirements of being anti-tarnishing, colorful, and excellent texture. The ceramic layer of the surface treated article of the present invention has excellent uniformity and is randomly and entirely coated on the surface of the substrate, and therefore is able to improve the decorative quality of the surface treated article.

According to the surface treated article of the present invention, preferably the thickness of the ceramic layer is 1 to 400 nm. The thickness of the ceramic layer of the present invention can be extremely thin (less than one micrometer) with high uniformity simultaneously and therefore the texture can be improved (i.e. the plastic texture can be avoided). Meanwhile, when the ceramic layer of the present invention has a thickness of about 1-10nm, the ceramic layer is thoroughly transparent. Alternatively, when thickness of the ceramic layer is about over 10nm, various desirable colors of the coated article can be revealed and changed arbitrarily thereby to achieve the improvement of the decorative quality.

According to the surface treated article of the present invention, preferably the material of the ceramic layer can be selected from a group consisted of: Al₂O₃, ZnO, TiO₂, ZrO₂, AlN, GaN, BN, TiN, SiC, Si₃N₄ and mixtures thereof, but is not limited thereto. The precursors used in the atomic layer deposition should vary depending on different selected ceramic materials. For example, when Al₂O₃ is selected as the material of the ceramic layer in the surface treated article of the present invention, trimethyl aluminum (TMA) and water may be used as the precursors in the atomic layer deposition process. Alternatively, when ZnO is selected as the material of the ceramic layer, diethyl zinc (DEZ) and water may be used as the precursors. Therefore, the precursors used during the atomic layer deposition process should be properly selected corresponding to the ceramic material.

According to the surface treated article of the present invention, preferably the color of the surface treated article may be different from the original color of the article's non-treated surface. Also, preferably the color of the surface treated article differs with different thickness of the ceramic layer coating on the article. In the present invention, the color of the surface treated article differs with different thickness of the ceramic layer. For example, when a ceramic layer of Al₂O₃ is formed on an article such as a silicon wafer in a thickness ranging from about 10nm to 250nm, the color of the ceramic layer-coated article gradually changes from dark yellow to blue green with the increase of the layer thickness. The sequence of the changed color is sequentially: dark yellow, blue violet, deep blue, blue, light blue, green, light gold, magenta, and blue green. When the thickness of the ceramic layer is over 250nm, the color will be changed repeatedly as the above changing sequence except the dark yellow color, which means the color of the ceramic layer will change from blue violet again to blue green and repeat to change from blue violet with the increasing of the film thickness.

Accordingly, the present invention provides a method of surface treatment and a surface treated article using the same. The surface treatment method of the present invention utilizes an atomic layer deposition (ALD) method to form a ceramic layer on a surface of the substrate, in which the formed ceramic layer has excellent uniformity and is randomly and entirely coated on the surface of the substrate. Therefore, the substrate (i.e. the article) that is surface treated by the method of the present invention is able to have a color the same as or different to that of the surface of the substrate and simultaneously prevent oxidation/tarnish occurring.

Other objects, advantages, and novel features of the invention will become more apparent from the following detailed description when taken in conjunction with the accompanying drawing.

Certain preferred embodiments of the present invention will now be described in greater detail by way of example only and with reference to the accompanying drawing in which:

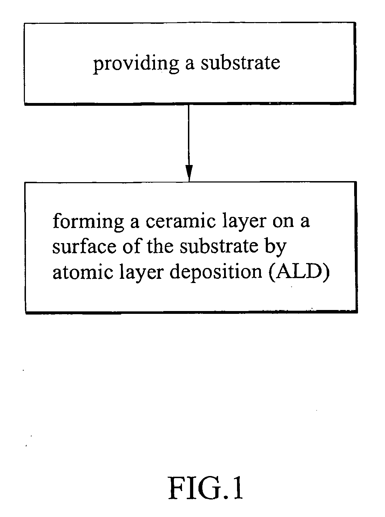

FIG. 1 is a process flow chart of surface treatment of the example 1.

### [Example 1]

With reference to Fig. 1, a process flow chart of surface treatment of the present example is shown. First, a silver ring is provided as the substrate of the present example. Then, trimethyl aluminum (TMA) and water are used as the precursors to perform an atomic layer deposition process to grow an Al₂O₃ ceramic layer with a growth rate of 0.8-1.5 Å/cycle (0.08-0.15 nm/cycle) and a reacting temperature of 50-300°C, in which the atomic layer deposition process is repeated upon 100 cycles. Accordingly, a thin film of Al₂O₃ with thickness of 10 nm is formed on the surface of the silver ring. Namely, a surface treated article of the present example is obtained. The formed Al₂O₃ thin film having thickness of 10nm is thoroughly transparent to the silver ring and enables the silver ring to have a more smooth texture and have an excellent anti-oxidation ability.

### [Examples 2-4]

In the present example, a silver/copper alloy ring is provided as the substrate; atomic layer deposition surface treatments are performed in the same way as the example 1, except that different materials and conditions (i.e. growth rate and reacting temperature) according to the table 1 listed below are used instead of those in the example 1.

**Table 1**

| | Material of the ceramic layer | Precursor 1 | Precursor 2 | Growth rate (Å/cycle) | Reacting temperature (°C) |
|---|---|---|---|---|---|
| Example 1 | Al₂O₃ | trimethyl aluminum (TMA) | H₂O | 0.8-1.5 | 50-300 |
| Example 2 | ZnO | diethyl zinc (DEZ) | H₂O | 0.8-2.0 | 120-300 |
| Example 3 | TiO₂ | titanium tetrachloride (TiCl₄) | H₂O | 0.6-0.8 | 150-300 |
| Example 4 | AlN | trimethyl aluminum (TMA) | H₂O | 0.6-1.5 | 250-550 |

### [Examples 5-14]

First, a glass piece is provided as the substrate. Then atomic layer deposition surface treatments are performed in the same way as the example 1, except that different repeated cycles are used to obtain different thicknesses of the ceramic layers according to the table 2 listed below instead of the thickness used in the example 1. The outer appearance colors of the surface treated glass pieces of the examples 5-14 are observed and the results are listed in the table 2 below.

**Table 2**

| | Thickness of the ceramic layer (nm) | Outer appearance color of the coated substrate |
|---|---|---|
| Example 5 | 1-10 | Original color of the non-coated substrate (color unchanged) |
| Example 6 | 10-30 | Dark yellow |
| Example 7 | 30-60 | Blue violet |
| Example 8 | 60-100 | Deep blue |
| Example 9 | 100-120 | Blue |
| Example 10 | 120- 140 | Light blue |
| Example 11 | 140-160 | Green |
| Example 12 | 160-180 | Light gold |
| Example 13 | 180-200 | Magenta |
| Example 14 | 200-250 | Blue green |
| | Over 250nm | Change from blue violet again to blue green and repeated |

It can be seen from the table 2, the color of the ceramic layer-coated substrate differs with different thicknesses of the ceramic layer, which means the method of surface treatment of the present invention can be used to change the color of the surface of the substrate. With reference to table 2, the color of the ceramic layer-coated substrate changes from dark yellow to blue green with the thickness change ranging from 10nm to 250nm. The sequence of the changed color is sequentially: dark yellow, blue violet, deep blue, blue, light blue, green, light gold, magenta, and blue green. Meanwhile, from the testing result of the inventor, it is observed that when the thickness of the ceramic layer is over 250nm, the color will be changed repeatedly as the above changing sequence except the dark yellow color, which means the color of the ceramic layer will change from blue violet again to blue green and repeat to change from blue violet with the increasing of the film thickness.

### [Examples 15-27]

First, a glass piece is provided as the substrate. Then atomic layer deposition surface treatments are performed in the same way as the example 1, except that different repeated cycles are used to obtain different thicknesses of the ceramic layers according to the table 3 listed below, and Si₃N₄ is used as the ceramic material instead of Al₂O₃. The outer appearance colors of the surface treated glass pieces of the examples 15-27 are observed and the results are listed in the table 3 below.

It should be noticed that the color change sequence is different with different ceramic materials, and the repeat starting point (thickness) is also different with different ceramic materials. With reference to table 3, from the results of the examples 15-27, it is observed that when Si₃N₄ is used as the ceramic material, the color change sequence is different from the sequence of the Al₂O₃ layer in the examples 5-14. The color of the Si₃N₄-coated substrate changes from tan with the thickness change ranging from 15nm to 1000nm, wherein only part of the results (thickness of 15nm to 350nm) is shown in the table 3. In detail, the color changes from 15nm to 350nm and keeps changing until the thickness reaches 1000nm, and is repeated from tan again starting at the thickness of 1000nm. Therefore, by the using of different ceramic materials, it is able to give desirable colors to the coated article. Hence, the method of the present invention can be applied to improve the decorative quality of the articles.

**Table 3**

| | Thickness of the ceramic layer (nm) | Outer appearance color of the coated substrate |
|---|---|---|
| Example 15 | 1-15 | Original color of the non-coated substrate (color unchanged) |
| Example 16 | 15-40 | Tan |
| Example 17 | 40-70 | Magenta |
| Example 18 | 70-100 | Blue |
| Example 19 | 100-115 | Light Blue |
| Example 20 | 115- 170 | Light yellow to gold |
| Example 21 | 170-200 | Orange to purple |
| Example 22 | 200-230 | Violet blue to blue |
| Example 23 | 230-240 | Blue green |
| Example 24 | 240-280 | Green |
| Example 25 | 280-300 | Green yellow to light orange |
| Example 26 | 310-330 | Pink |
| Example 27 | 330-350 | Red |

### [Testing example] BS EN ISO 4538: 1995 Thioacetamide tarnish test

The surface treated silver ring of the example 1 is taken to a thioacetamide corrosion test. The surface treated silver ring is placed in a closed, gas-tight chamber (not shown) that contains a saturated solution of sodium acetate tri-hydrate and thioacetamide distributed on a horizontal plate within the chamber (50mg per square decimeter of surface). This ensures a relative humidity of 75% at 20 ± 5°C within the sealed container. The sample sat 35 mm above the plate at an ambient temperature of 24°C. After 24 hours, the surface treated silver ring is observed, and the results show no oxidation/corrosion phenomenon has occurred, which proves the ability of oxidation/tarnish-preventing of the method of the present invention.

Accordingly, the present invention provides a method of surface treatment and a surface treated article using the same. The surface treatment method of the present invention utilizes an atomic layer deposition (ALD) method to form a ceramic layer on a surface of the substrate, in which the formed ceramic layer has excellent uniformity and is randomly and entirely coated on the surface of the substrate. Therefore, the substrate (i.e. the article) that is surface treated by the method of the present invention is able to have the color of the surface changed and simultaneously prevent oxidation/tarnish occurring.

Although the present invention has been explained in relation to its preferred embodiment, it is to be understood that many other possible modifications and variations can be made without departing from the scope of the invention as hereinafter claimed.

## Claims

1. A method of surface treatment, comprising:
providing a substrate; and
forming a ceramic layer on a surface of the substrate by atomic layer deposition (ALD), wherein the ceramic layer has a thickness of 1nm to 1000 nm.

2. The method of surface treatment as claimed in claim 1, wherein the substrate has an irregular shape.

3. The method of surface treatment as claimed in claim 1 or 2, wherein a material of the ceramic layer is selected from a group consisted of: Al₂O₃, ZnO, TiO₂ ZrO₂ AlN, GaN, BN, TiN, SiC, Si₃N₄, and mixtures thereof.

4. The method of surface treatment as claimed in claim 1, 2 or 3, wherein the thickness of the ceramic layer is 1 to 400 nm.

5. The method of surface treatment as claimed in any preceding claim, wherein the method of surface treatment is used to change the color of the surface of the substrate.

6. The method of surface treatment as claimed in any preceding claim, wherein the forming of the ceramic layer the atomic layer deposition is repeated 1 to 10000 times.

7. The method of surface treatment as claimed in any preceding claim, wherein the color of the ceramic layer-coated substrate differs with different thicknesses of the ceramic layer.

8. The method of surface treatment as claimed in any preceding claim, wherein the method of surface treatment is used to prevent oxidation of the substrate.

9. The method of surface treatment as claimed in any preceding claim, wherein the substrate is a metal substrate, a glass substrate, a quartz substrate, or a polymer substrate.

10. The method of surface treatment as claimed in any preceding claim, wherein a reacting temperature of the atomic layer deposition method is 50 to 650 °C.

11. A surface treated article, which comprises an article coated with a ceramic layer by atomic layer deposition (ALD), wherein the coated ceramic layer has a thickness of 1nm to 1000 nm.

12. The surface treated article as claimed in claim 11, wherein the thickness of the ceramic layer is 1 to 400nm.

13. The surface treated article as claimed in claim 11 or 12, wherein the material of the ceramic layer is selected from a group consisted of: Al₂O₃, ZnO, TiO₂ ZrO₂ AlN, GaN, BN, TiN, SiC, Si₃N₄ and mixtures thereof.

14. The surface treated article as claimed in claim 11, 12 or 13, wherein the color of the surface treated article is different from the original color of the non-treated surface of the article.

15. The surface treated article as claimed in claim 11, 12, 13 or 14, wherein the color of the surface treated article differs with different thicknesses of the ceramic layer coating on the article.
